# EUROPEAN PATENT APPLICATION

(11) **EP 2 966 694 A1**
(43) Date of publication of application: **13.01.2016**
(21) Application number: 13877306.4
(22) Date of filing: 08.03.2013
(51) Int. Cl.: H01L 31/042

(54) **ENCAPSULANTS FOR SOLAR BATTERY, AND SOLAR BATTERY MODULE**

(71) Applicant: C. I. Kasei Company, Limited, Tokyo 104-8321 (JP)
(72) Inventor: TAKAYANAGI Akihiro, Tokyo 104-8321 (JP); KOSHIDA Shirei, Tokyo 104-8321 (JP); HORI Akira, Tokyo 104-8321 (JP)
(74) Representative: Treeby, Philip David William
(86) International application number: PCT/JP2013/056488
(87) International publication number: WO 2014/136260

(57) **Abstract**

Disclosed is a pair of encapsulants (12) for encapsulating a solar battery cell (11) including incident surface side encapsulants arranged on an incident surface side of solar light of the solar battery cell (11), and back surface side encapsulants arranged on a back surface side of the solar battery cell (11), in which the incident surface side encapsulants contain an ethylene-vinyl acetate copolymer and an epoxy compound, and the back surface side encapsulants contain an ethylene-vinyl acetate copolymer and an acid accepting agent formed of a metal compound.

## Description

### Technical Field

The present invention relates to a pair of encapsulants for a solar battery for encapsulating a solar battery cell, and a solar battery module in which a solar battery cell is encapsulated by the encapsulants for a solar battery.

Priority is claimed on Japanese Patent Application No. 2011-265061, filed December 2, 2011, the content of which is incorporated herein by reference.

### Background Art

An ethylene-vinyl acetate copolymer sheet is generally used as encapsulants for a solar battery for encapsulating a solar battery cell.

However, an ethylene-vinyl acetate copolymer easily generates an acetic acid through hydrolysis.

The acetic acid generated in the encapsulants for a solar battery corrodes a metal portion of a solar battery module (an electrode of the solar battery cell, a conductive wire of a tab string, and the like).

As encapsulants for a solar battery in which corrosion of the metal portion due to the acetic acid is limited, the following encapsulants for a solar battery have been proposed.
(1) Encapsulants for a solar battery in which an acid accepting agent such as a metal oxide, and a metal hydroxide is mixed into an ethylene-vinyl acetate copolymer in an amount of less than or equal to 0.5 mass% (Patent Document 1).

However, the encapsulants for a solar battery of (1) contain the acid accepting agent such as a metal oxide, and a metal hydroxide, and thus transparency deteriorates compared to encapsulants for a solar battery which do not contain the acid accepting agent. For this reason, in a solar battery module using the encapsulants for a solar battery of (1), power generation efficiency decreases compared to a solar battery module using the encapsulants for a solar battery which do not contain the acid accepting agent.

As encapsulants for a solar battery in which a decrease in transparency due to the acid accepting agent is limited while limiting corrosion of the metal portion due to the acetic acid by the acid accepting agent, the following encapsulants for a solar battery have been proposed.
(2) A pair of encapsulants for a solar battery including incident surface side encapsulants in which an ethylene-vinyl acetate copolymer and an acid accepting agent such as a metal oxide, and a metal hydroxide are contained, and the amount of the acid accepting agent is less than or equal to 0.15 parts by mass with respect to 100 parts by mass of the ethylene-vinyl acetate copolymer; and back surface side encapsulants in which an ethylene-vinyl acetate copolymer and an acid accepting agent such as a metal oxide, and a metal hydroxide are contained, and an amount of the acid accepting agent is greater than or equal to 0.5 parts by mass with respect to 100 parts by mass of the ethylene-vinyl acetate copolymer (Patent Document 2).

However, even in the encapsulants for a solar battery of (2), the incident surface side encapsulants contain the acid accepting agent such as a metal oxide, and a metal hydroxide, and thus the transparency deteriorates compared to encapsulants for a solar battery which do not contain the acid accepting agent. For this reason, in a solar battery module using the encapsulants for a solar battery of (2), power generation efficiency decreases compared to a solar battery module using the encapsulants for a solar battery which do not contain the acid accepting agent.

### Citation List

### Patent Document

[Patent Document 1] Japanese Unexamined Patent Application, First Publication No. 2005-029588
[Patent Document 2] Japanese Unexamined Patent Application, First Publication No. 2009-179810

### Summary of Invention

### Technical Problem

The present invention provides encapsulants for a solar battery in which corrosion of a metal portion (an electrode of a solar battery cell, a conductive wire of a tab string, and the like) due to an acetic acid is limited, and the transparency of incident surface side encapsulants is high; and a solar battery module in which corrosion of the metal portion due to the acetic acid is limited, and the power generation efficiency is high.

### Solution to Problem

According to an aspect of the present invention, there is provided a pair of encapsulants for a solar battery for encapsulating a solar battery cell including incident surface side encapsulants arranged on an incident surface side of solar light of the solar battery cell, and back surface side encapsulants arranged on a back surface side of the solar battery cell, in which the incident surface side encapsulants contain an ethylene-vinyl acetate copolymer and an epoxy compound, and the back surface side encapsulants contain an ethylene-vinyl acetate copolymer, and an acid accepting agent formed of a metal compound.

According to another aspect of the present invention, there is provided a solar battery module, in which a solar battery cell is encapsulated by the encapsulants for a solar battery according to claim 1.

### Effects of Invention

In the encapsulants for a solar battery of the present invention, corrosion of the metal portion (an electrode of a solar battery cell, a conductive wire of a tab string, and the like) due to the acetic acid is limited, and the transparency of the incident surface side encapsulants is high.

In the solar battery module of the present invention, corrosion of the metal portion due to the acetic acid is limited, and the power generation efficiency is high.

### Brief Description of Drawings

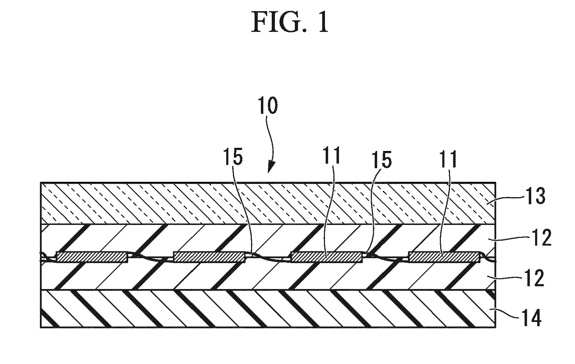

FIG. 1 is a sectional view showing an example of a solar battery module of the present invention.

### Description of Embodiments

### <Encapsulants for Solar Battery>

Encapsulants for a solar battery (hereinafter, referred to as encapsulants) of the present invention are a pair of encapsulants for encapsulating a solar battery cell, and includes incident surface side encapsulants arranged on an incident surface side of solar light of the solar battery cell, and back surface side encapsulants arranged on a back surface side of the solar battery cell.

### [Incident Surface Side Encapsulants]

The incident surface side encapsulants contain an ethylene-vinyl acetate copolymer (hereinafter, referred to as EVA) and an epoxy compound, and are formed of a sheet which do not contain an acid accepting agent formed of a metal compound.

### (EVA)

The amount of a vinyl acetate unit in the EVA is preferably 10 mass% to 40 mass%, is more preferably 15 mass% to 35 mass%, and is even more preferably 20 mass% to 35 mass%. When the amount of the vinyl acetate unit in the EVA is greater than or equal to the lower limit value described above, the transparency and adhesiveness of the encapsulants are able to be high at the time of manufacturing a solar battery module, and when the amount of the vinyl acetate unit in the EVA is less than or equal to the upper limit value described above, a higher durability can be achieved.

The mass average molecular weight of the EVA is preferably 10,000 to 300,000, is more preferably 30,000 to 250,000, and is even more preferably 50,000 to 200,000. When the mass average molecular weight of the EVA is greater than or equal to the lower limit value described above, the mechanical properties of the encapsulants at the time of manufacturing the solar battery module are able to be excellent, and when the mass average molecular weight of the EVA is less than or equal to the upper limit value described above, the workability of the encapsulants is able to be excellent.

### (Epoxy Compound)

The epoxy compound is a compound having an epoxy group in the molecule.

When the epoxy compound is contained in the encapsulants, an acetic acid generated due to deterioration of the EVA is able to react with the epoxy compound. Accordingly, the acetic acid is able to be inactivated, and thus corrosion of a metal portion (an electrode of a solar battery cell, a conductive wire of a tab string, and the like) due to the acetic acid is able to be limited, and a decrease in the extracted amount of electric power is able to be prevented. In addition, the epoxy compound is a non-particulate organic matter, and thus a decrease in the transparency of the encapsulants is able to be limited.

The epoxy compound may have at least one epoxy group.

Examples of a commercially available epoxy compound include ADEKA Resin EP4100E (manufactured by ADEKA Corporation, a bisphenol A type epoxy compound), Denacol EX-121 (manufactured by Nagase ChemteX Corporation, 2-ethyl hexyl glycidyl ether), Denacol EX-141 (manufactured by Nagase ChemteX Corporation, phenyl glycidyl ether), Denacol EX-810 (manufactured by Nagase ChemteX Corporation, ethylene glycol diglycidyl ether and polyethylene glycol diglycidyl ether), and the like.

One type of the epoxy compounds may be independently used, or two or more types thereof may be used in combination.

Among the epoxy compounds, a chelate modified epoxy compound may discolor the encapsulants, and thus is not preferable.

The molecular weight of the epoxy compound is preferably greater than or equal to 100, and is more preferably greater than or equal to 130 from a viewpoint of limiting bleed-out from the encapsulants. However, when the molecular weight excessively increases, compatibility with respect to the EVA decreases, and thus the molecular weight is preferably less than or equal to 30,000, and is more preferably less than or equal to 20,000. Examples of the epoxy compound having a molecular weight of 100 to 30,000 include an epoxy compound used in a monomer of an epoxy resin.

The amount of the epoxy compound is preferably 0.001 parts by mass to 5 parts by mass, and is more preferably 0.5 parts by mass to 1.0 parts by mass, with respect to 100 parts by mass of the EVA contained in the incident surface side encapsulants. When the amount of the epoxy compound is greater than or equal to the lower limit value described above, corrosion of the metal portion is able to be sufficiently limited at the time of manufacturing the solar battery module, and when the amount of the epoxy compound is less than or equal to the upper limit value described above, the mechanical properties of the encapsulants at the time of manufacturing the solar battery module are able to be excellent.

### (Triazole Compound)

The incident surface side encapsulants may contain a triazole compound.

The triazole compound is a derivative in which triazole or a hydrogen atom of a nitrogen-containing heterocycle of triazole is substituted with a substituent group. However, benzotriazole is not included in the triazole compound.

Examples of the substituent group include alkyl groups such as a methyl group, an ethyl group, and a propyl group. The alkyl group may be further substituted with an amino group, a halogen atom, and the like.

The triazole compound is able to prevent the EVA from being discolored due to copper ions generated from a conductive wire of a tab string or a solder joint portion. For this reason, durability of the encapsulants at the time of manufacturing the solar battery module is able to be excellent, and coloring and foaming of the EVA are limited. In addition, the solar battery module using the encapsulants has excellent power generation efficiency and appearance.

Examples of a commercially available triazole compound include Irgamet 30 (manufactured by BASF Coatings Japan Ltd., N,N-bis(2-ethyl hexyl)-1,2,4-triazole-1-yl methanamine), Adekastab CDA-1 (manufactured by ADEKA Corporation, 3-(N-salicyloyl)amino-1,2,4-triazole), and the like.

One type of the triazole compounds may be independently used, or two or more types thereof may be used in combination.

The amount of the triazole compound is preferably 0.001 parts by mass to 5 parts by mass, and is more preferably 0.01 parts by mass to 0.5 parts by mass, with respect to 100 parts by mass of the EVA contained in the incident surface side encapsulants. When the amount of the triazole compound is greater than or equal to the lower limit value described above, the durability is higher at the time of manufacturing the solar battery module, and opacification is further limited, and when the amount of the triazole compound is less than or equal to the upper limit value described above, the mechanical properties of the encapsulants at the time of manufacturing the solar battery module are excellent.

### (Additive)

The incident surface side encapsulants may contain additives such as an ultraviolet absorbent, a photo-stabilizer, an antioxidant, a silane coupling agent, a crosslinking agent, and a crosslinking auxiliary.

Examples of the ultraviolet absorbent include a benzophenone-based ultraviolet absorbent, a benzotriazole-based ultraviolet absorbent, a salicylic acid ester-based ultraviolet absorbent, and the like.

Examples of the photo-stabilizer include a hindered amine-based photo-stabilizer, and the like.

Examples of the antioxidant include a hindered phenol-based antioxidant, a phosphite-based antioxidant, and the like.

The silane coupling agent is a component for improving adhesiveness with respect to the solar battery cell described below, a transparent protective material, a back sheet, or the like. Examples of the silane coupling agent include vinyl triethoxy silane, vinyl tris(2-methoxy ethoxy)silane, 3-methacryloxy propyl trimethoxy silane, 3-glycidoxy propyl trimethoxy silane, N-2-(amino ethyl)-3-amino propyl trimethoxy silane, N-2-(amino ethyl)-3-amino propyl methyl dimethoxy silane, 3-amino propyl triethoxy silane, 3-mercaptopropyl trimethoxy silane, and the like.

The amount of the silane coupling agent is preferably 0 parts by mass to 10 parts by mass, and is more preferably 0 parts by mass to 5 parts by mass, with respect to 100 parts by mass of the EVA contained in the incident surface side encapsulants.

The crosslinking agent is a component for crosslinking the EVA. Examples of the crosslinking agent include known organic peroxides (peroxyketals, dialkyl peroxides, peroxyesters, and the like), a photosensitizer, and the like.

The amount of the crosslinking agent is preferably 0 parts by mass to 5 parts by mass, and is more preferably 0 parts by mass to 2 parts by mass, with respect to 100 parts by mass of the EVA contained in the incident surface side encapsulants.

The crosslinking auxiliary is a compound having one or more (preferably two or more) polymerizable unsaturated groups (a vinyl group, an allyl group, a (meth)acryloxy group, and the like). Examples of the compound include triallyl isocyanurate, triallyl cyanurate, trimethylol propane trimethacrylate, and the like.

The amount of the crosslinking auxiliary is preferably 0 parts by mass to 5 parts by mass, and is more preferably 0 parts by mass to 2 parts by mass, with respect to 100 parts by mass of the EVA contained in the incident surface side encapsulants.

The incident surface side encapsulants may contain a discoloring inhibitor, a pigment, a dye, a filling material, and the like (however, a metal compound functioning as an acid accepting agent is excluded) within a range not impairing the effects of the present invention.

### (Thickness)

The thickness of the sheet-like incident surface side encapsulants is within a range of 0.05 mm to 1 mm according to a solar battery module to be prepared. When the thickness of the encapsulants is greater than or equal to 0.05 mm, it is possible to sufficiently encapsulate the solar battery cell, and when the thickness of the encapsulants is less than or equal to 1 mm, it is possible to make a thin solar battery.

### (Manufacturing Method of Incident Surface Side Encapsulants)

Examples of a manufacturing method of the incident surface side encapsulants include a method in which a mixture is prepared by mixing EVA, an epoxy compound, and as necessary, an additive, and the mixture is formed into a sheet by being molded.

Examples of the method of forming a sheet, for example include an extrusion molding method using a T-die, a press molding method, and the like. In addition, a sheet is able to be formed by applying a solution of the encapsulants onto release sheet, and by drying the solution.

### [Back Surface Side Encapsulants]

The back surface side encapsulants are formed of a sheet containing EVA, and an acid accepting agent formed of a metal compound.

### (EVA)

Examples of the EVA include the same examples as those of the EVA used in the incident surface side encapsulants.

### (Acid Accepting Agent Formed of Metal Compound)

The acid accepting agent formed of the metal compound is a metal compound having a function of absorbing and/or neutralizing an acetic acid.

When the acid accepting agent formed of the metal compound is contained in the encapsulants, an acetic acid generated due to deterioration of the EVA is able to react with the acid accepting agent formed of the metal compound. Accordingly, the acetic acid is able to be inactivated, and thus corrosion of the metal portion (the electrode of the solar battery cell, the conductive wire of the tab string, and the like) due to the acetic acid is able to be limited, and a decrease in the extracted amount of electric power is able to be prevented.

The acid accepting agent formed of the metal compound is arbitrarily selected, and examples of the acid accepting agent formed of the metal compound include a metal oxide, a metal hydroxide, a metal carbonate, and the like. It is preferable that the acid accepting agent formed of the metal compound is one or more selected from a group consisting of a metal oxide and a metal hydroxide from a viewpoint of increasing the effect of limiting the corrosion of the metal portion.

Examples of the metal oxide include magnesium oxide, calcium oxide, zinc oxide, trilead tetraoxide, tin oxide, silicon oxide, aluminum oxide, and the like.

Examples of the metal hydroxide include a magnesium hydroxide, a calcium hydroxide, a barium hydroxide, an iron hydroxide, a composite metal hydroxide (hydrotalcites and the like), an aluminum hydroxide gel compound, and the like.

Examples of the metal carbonate include a magnesium carbonate, a barium carbonate, a calcium carbonate, a basic tin carbonate, and the like.

Examples of other metal compounds include calcium borate, zinc stearate, calcium phthalate, calcium phosphite, zinc oxide, calcium silicate, magnesium silicate, magnesium borate, magnesium metaborate, calcium metaborate, barium metaborate, tin stearate, basic tin phosphite, basic tin sulfite, silicon stearate, and the like.

One type of the acid accepting agents formed of the metal compound may be independently used, or a combination of two or more types thereof may be used.

The average particle diameter of the acid accepting agent formed of the metal compound is preferably less than or equal to 5 mm, is more preferably 1 mm to 4 mm, and is even more preferably 1 mm to 2.5 mm. When the average particle diameter is less than or equal to the upper limit value described above, the surface area of the total particles per mass increases, and the contact area with respect to the acetic acid increases. Therefore, it is possible to sufficiently limit corrosion of the metal portion at the time of manufacturing the solar battery module.

The amount of the acid accepting agent formed of the metal compound is preferably 0.05 parts by mass to 5 parts by mass, and is more preferably 0.1 parts by mass to 4 parts by mass, with respect to 100 parts by mass of the EVA contained in the back surface side encapsulants. When the amount of the acid accepting agent formed of the metal compound is greater than or equal to the lower limit value described above, it is possible to sufficiently limit corrosion of the metal portion at the time of manufacturing the solar battery module, and when the amount of the acid accepting agent formed of the metal compound is less than or equal to the upper limit value described above, it is possible to make the mechanical properties of the encapsulants at the time of manufacturing the solar battery module excellent.

### (Epoxy Compound)

The back surface side encapsulants may contain an epoxy compound.

Examples of the epoxy compound include the same examples as those of the epoxy compound used in the incident surface side encapsulants. A preferred aspect of the epoxy compound is also identical to that of the incident surface side encapsulants.

### (Triazole Compound)

The back surface side encapsulants may contain a triazole compound.

Examples of the triazole compound include the same examples as those of the triazole compound used in the incident surface side encapsulants. A preferred aspect of the triazole compound is also identical to that of the incident surface side encapsulants.

### (Additive)

The back surface side encapsulants may contain the additives described above such as an ultraviolet absorbent, a photo-stabilizer, an antioxidant, a silane coupling agent, a crosslinking agent, and a crosslinking auxiliary.

Examples of the various additives include the same examples as those of the various additives used in the incident surface side encapsulants. A preferred aspect of the additive is also identical to that of the incident surface side encapsulants.

The back surface side encapsulants may contain a discoloring inhibitor, a pigment, a dye, a filling material, and the like (however, a metal compound functioning as an acid accepting agent is excluded) within a range not impairing the effect of the present invention.

### (Thickness)

The thickness of the sheet-like back surface side encapsulants is within a range of 0.05 mm to 1 mm according to a solar battery module to be prepared. When the thickness of the encapsulants is greater than or equal to 0.05 mm, it is possible to sufficiently encapsulate the solar battery cell, and when the thickness of the encapsulants is less than or equal to 1 mm, it is possible to make a thin solar battery.

### (Manufacturing Method of Back Surface Side Encapsulants)

Examples of a manufacturing method of the back surface side encapsulants include a method in which a mixture is prepared by mixing EVA, an acid accepting agent formed of a metal compound, and as necessary, an additive, and the mixture is formed into a sheet by being molded.

Examples of the method of forming a sheet include an extrusion molding method using a T-die, a press molding method, and the like. In addition, a sheet is able to be formed by applying a solution of the encapsulants onto a release sheet encapsulants, and by drying the solution.

### (Functional Effect)

In the encapsulants for a solar battery of the present invention described above, the incident surface side encapsulants contain the EVA and the epoxy compound, and the back surface side encapsulants contain the EVA and the acid accepting agent formed of the metal compound. Therefore, it is possible to limit corrosion of the metal portion due to the acetic acid.

In addition, the epoxy compound does not decrease the transparency of the encapsulants unlike the acid accepting agent formed of the metal compound, and thus it is possible to maintain the high transparency of the incident surface side encapsulants.

In addition, the epoxy compound contained in the incident surface side encapsulants reacts with the acetic acid, and thus the amount thereof decreases. Therefore, it is not possible to limit corrosion of the metal portion due to the acetic acid for an extended period of time. In contrast, the acid accepting agent formed of the metal compound which is contained in the back surface side encapsulants is able to limit corrosion of the metal portion due to the acetic acid for an extended period of time compared to the epoxy compound, and the amount thereof is able to be increased. Therefore, the acid accepting agent formed of the metal compound which is contained in the back surface side encapsulants is able to limit corrosion of the metal portion due to the acetic acid for an extended period of time.

### <Solar Battery Module>

FIG. 1 is a sectional view showing an example of the solar battery module of the present invention.

A solar battery module 10 includes a plurality of solar battery cells 11; a pair of encapsulants 12 encapsulating the solar battery cells 11 by interposing the solar battery cells 11 therebetween; and a transparent protective material 13 and a back sheet 14 bonded by the encapsulants 12.

In the solar battery module 10, the encapsulants 12 on an incident surface side of solar light of the solar battery cell 11 are the incident surface side encapsulants described above, and the encapsulants on a back surface side of the solar battery cell 11 are the back surface side encapsulants described above.

In addition, the transparent protective material 13 is disposed on a side in which the transparent protective material 13 is in contact with the incident surface side encapsulants, and the back sheet 14 is disposed on a side in which the back sheet 14 is in contact with the back surface side encapsulants.

### (Solar Battery Cell)

Examples of the solar battery cell 11 include a pn junction type solar battery device having a structure to which a p type or an n type semiconductor is joined. Examples of the pn junction type solar battery device include a silicon-based solar battery device (a single crystal silicon-based solar battery device, a polycrystal silicon-based solar battery device, an amorphous silicon-based solar battery device, and the like), a compound-based solar battery device (a GaAs-based solar battery device, a CIS-based solar battery device, and a CdTe-CdS-based solar battery device), and the like.

In the solar battery module 10, the plurality of solar battery cells 11 are electrically connected in series through a conductive wire and a tab string 15 including a solder joint portion.

### (Transparent Protective Material)

Examples of the transparent protective material 13 include a glass plate, a resin plate, and the like. Figured glass is preferable as the glass plate having concavities and convexities on a surface from a viewpoint of light transmittivity. A white glass plate (high transmissive glass) having a small amount of iron is preferable as the material of the figured glass.

### (Back Sheet)

Examples of the material of the back sheet 14 include polyvinyl chloride, polyester (polyethylene terephthalate or the like), polyolefin (polyethylene or the like), glass, metal (aluminum or the like), and the like. The back sheet 24 may be a single layer, or may be a plurality of layers.

### (Manufacturing Method of Solar Battery Module)

Examples of a manufacturing method of the solar battery module include a method in which the plurality of solar battery cells 11 electrically connected using the tab string 15 are interposed between a pair of encapsulants 12, the encapsulants 12 are interposed between the transparent protective material 13 and the back sheet 14, and then are heated, and the encapsulants 12, the encapsulants 12 and the transparent protective material 13, and the encapsulants 12 and the back sheet 14 adhere to each other.

When the encapsulants 12 contain a crosslinking agent, it is preferable that the encapsulants 12 are heated to a temperature of higher than or equal to the 10-hour half-life temperature of the crosslinking agent. When the encapsulants 12 are heated to a temperature of higher than or equal to the 10-hour half-life temperature of the crosslinking agent, the EVA contained in the encapsulants 12 is able to be crosslinked, and the durability of the encapsulants 12 is able to be further improved.

### (Functional Effect)

In the solar battery module of the present invention described above, the solar battery cell is encapsulated by the encapsulants for a solar battery of the present invention which limit corrosion of the metal (the electrode of the solar battery cell, the conductive wire of the tab string, and the like) due to the acetic acid and have high transparency in the incident surface side encapsulants, and thus corrosion of the metal portion due to the acetic acid is limited, and the power generation efficiency is high.

Furthermore, in the present invention, the expression of "plurality" indicates an arbitrary number, that is, at least two.

### [Examples]

### [Example 1]

0.5 parts by mass of an ultraviolet absorbent (TINUVIN P, manufactured by BASF Japan Ltd.), 0.5 parts by mass of a photo-stabilizer (TINUVIN 114, manufactured by BASF Japan Ltd.), 0.5 parts by mass of a silane coupling agent (KBE-502, manufactured by Shin-Etsu Chemical Co., Ltd.), 0.5 parts by mass of a crosslinking agent (Kaya Ester AN, manufactured by Kayaku Akzo Co., Ltd.), 0.5 parts by mass of a crosslinking auxiliary (Taic, manufactured by Nihon Kasei Co., Ltd.), 0.5 parts by mass of a triazole compound (Adekastab CDA-10, manufactured by ADEKA Corporation), and 1.0 parts by mass of an epoxy compound A (ADEKA Resin EP4100E, manufactured by ADEKA Corporation, and a molecular weight: 16340) were mixed into 100 parts by mass of EVA (SEETEC VE700, manufactured by Lotte Chemical Corporation, the amount of a vinyl acetate unit: 30 mass%, and a mass average molecular weight: 130,000), and thus a composition for incident surface side encapsulants was obtained. Subsequently, the composition for incident surface side encapsulants was press molded, and thus sheet-like incident surface side encapsulants having a thickness of 500 mm were obtained.

A composition for back surface side encapsulants was obtained by the same method as that of the composition for incident surface side encapsulants except that a metal oxide A (PUREMAG FNM-G, manufactured by Tateho Chemical Industries Co., Ltd.) was used instead of the epoxy compound A. Subsequently, the composition for back surface side encapsulants was press molded, and thus sheet-like back surface side encapsulants having a thickness of 500 mm were obtained.

A plurality of polycrystal silicon-based solar battery cells electrically connected in series were interposed between the incident surface side encapsulants and the back surface side encapsulants, and the solar battery cells, the incident surface side encapsulants, and the back surface side encapsulants were interposed between a glass plate and a back sheet formed of polyvinyl chloride and polyester. Therefore, a laminated body was obtained. This laminated body was put into a resin bag, the inside of the bag was vacuated and was heated at 128 C, and the encapsulants, the encapsulants and the glass plate, and the encapsulants and the back sheet were pressed in advance. Further, the laminated body which was pressed in advance was heated in a heating furnace of 150 C, and thus a solar battery module was obtained.

### [Example 2]

A solar battery module was obtained by the same method as that in Example 1 except that the mixed amount of the epoxy compound A was changed to 0.001 parts by mass.

### [Example 3]

A solar battery module was obtained by the same method as that in Example 1 except that the mixed amount of the epoxy compound A was changed to 5.0 parts by mass.

### [Example 4]

A solar battery module was obtained by the same method as that in Example 1 except that the epoxy compound A was changed to an epoxy compound B (Denacol EX-810, manufactured by Nagase ChemteX Corporation, and a molecular weight: 218).

### [Example 5]

A solar battery module was obtained by the same method as that in Example 1 except that the mixed amount of the metal oxide A was changed to 0.5 parts by mass.

### [Example 6]

A solar battery module was obtained by the same method as that in Example 1 except that the mixed amount of the metal oxide A was changed to 5.0 parts by mass.

### [Example 7]

A solar battery module was obtained by the same method as that in Example 1 except that the metal oxide A was changed to a metal oxide B (HP-30, manufactured by Konoshima Chemical Co., Ltd.).

### [Example 8]

A solar battery module was obtained by the same method as that in Example 1 except that the metal oxide A was changed to a metal hydroxide A (Kisuma 5Q, manufactured by Kyowa Chemical Industry Co., Ltd.).

### [Comparative Example 1]

A solar battery module was obtained by the same method as that in Example 1 except that the epoxy compound A of the incident surface side encapsulants was changed to the metal oxide A.

### [Comparative Example 2]

A solar battery module was obtained by the same method as that in Example 1 except that the epoxy compound A was not mixed into the incident surface side encapsulants.

### [Comparative Example 3]

A solar battery module was obtained by the same method as that in Example 1 except that the metal oxide A was not mixed into the back surface side encapsulants.

### [Evaluation]

### (Power Generation Performance)

The I-V characteristic of the obtained solar battery module was measured by using a solar simulator (PVS1114iD, manufactured by Nisshinbo Mechatronics Inc.), and thus initial power generation performance was obtained. The results are shown in Table 1 and Table 2.

### (Appearance of Tab String)

The obtained solar battery module was placed under a humid and hot environment of a temperature of 85 C and relative humidity of 85% for 1000 hours, and then the appearance of a tab string was visually observed and was evaluated on the basis of the following criteria. The evaluation results are shown in Table 1 and Table 2.

A: None of rusting, discoloring, and clouding is observed.

B: Any one of rusting, discoloring, and clouding is slightly observed, but the solar battery module is able to be used.

C: Any one of rusting, discoloring, and clouding is observed, and the solar battery module is not able to be used.

**[Table 1]**

| | Examples | | | | | | | |
|---|---|---|---|---|---|---|---|---|
| | 1 | 2 | 3 | 4 | 5 | 6 | 7 | 8 |
| Incident Surface Side Encapsulants (Parts by Mass) | | | | | | | | |
| EVA | 100 | 100 | 100 | 100 | 100 | 100 | 100 | 100 |
| Ultraviolet Absorbent | 0.5 | 0.5 | 0.5 | 0.5 | 0.5 | 0.5 | 0.5 | 0.5 |
| Photo-Stabilizer | 0.5 | 0.5 | 0.5 | 0.5 | 0.5 | 0.5 | 0.5 | 0.5 |
| Silane Coupling Agent | 0.5 | 0.5 | 0.5 | 0.5 | 0.5 | 0.5 | 0.5 | 0.5 |
| Crosslinking Agent | 0.5 | 0.5 | 0.5 | 0.5 | 0.5 | 0.5 | 0.5 | 0.5 |
| Crosslinking Auxiliary | 0.5 | 0.5 | 0.5 | 0.5 | 0.5 | 0.5 | 0.5 | 0.5 |
| Triazole | 0.5 | 0.5 | 0.5 | 0.5 | 0.5 | 0.5 | 0.5 | 0.5 |
| Epoxy Compound A | 1.0 | 0.001 | 5.0 | | 1.0 | 1.0 | 1.0 | 1.0 |
| Epoxy Compound B | | | | 1.0 | | | | |
| Metal Oxide A | | | | | | | | |

| Back Surface Side Encapsulants (Parts by Mass) | | | | | | | | |
|---|---|---|---|---|---|---|---|---|
| EVA | 100 | 100 | 100 | 100 | 100 | 100 | 100 | 100 |
| Ultraviolet Absorbent | 0.5 | 0.5 | 0.5 | 0.5 | 0.5 | 0.5 | 0.5 | 0.5 |
| Photo-Stabilizer | 0.5 | 0.5 | 0.5 | 0.5 | 0.5 | 0.5 | 0.5 | 0.5 |
| Silane Coupling Agent | 0.5 | 0.5 | 0.5 | 0.5 | 0.5 | 0.5 | 0.5 | 0.5 |
| Crosslinking Agent | 0.5 | 0.5 | 0.5 | 0.5 | 0.5 | 0.5 | 0.5 | 0.5 |
| Crosslinking Auxiliary | 0.5 | 0.5 | 0.5 | 0.5 | 0.5 | 0.5 | 0.5 | 0.5 |
| Triazole | 0.5 | 0.5 | 0.5 | 0.5 | 0.5 | 0.5 | 0.5 | 0.5 |
| Metal Oxide A | 1.0 | 1.0 | 1.0 | 1.0 | 0.5 | 5.0 | | |
| Metal Oxide B | | | | | | | 1.0 | |
| Metal Hydroxide A | | | | | | | | 1.0 |
| Power Generation Performance [%] | 15.41 | 15.35 | 15.38 | 15.42 | 15.35 | 15.37 | 15.40 | 15.38 |
| Appearance of Tab String | A | A | A | A | A | A | A | A |
| Transparency | A | A | A | A | A | A | A | A |

**[Table 2]**

| | Comparative Examples | | |
|---|---|---|---|
| | 1 | 2 | 3 |
| Incident Surface Side Encapsulants (Parts by Mass) | | | |
| EVA | 100 | 100 | 100 |
| Ultraviolet Absorbent | 0.5 | 0.5 | 0.5 |
| Photo-Stabilizer | 0.5 | 0.5 | 0.5 |
| Silane Coupling Agent | 0.5 | 0.5 | 0.5 |
| Crosslinking Agent | 0.5 | 0.5 | 0.5 |
| Crosslinking Auxiliary | 0.5 | 0.5 | 0.5 |
| Triazole | 1.0 | 1.0 | 1.0 |
| Epoxy Compound A | | | 1.0 |
| Epoxy Compound B | | | |
| Metal Oxide A | 1.0 | | |

| Back Surface Side Encapsulants (Parts by Mass) | | | |
|---|---|---|---|
| EVA | 100 | 100 | 100 |
| Ultraviolet Absorbent | 0.5 | 0.5 | 0.5 |
| Photo-Stabilizer | 0.5 | 0.5 | 0.5 |
| Silane Coupling Agent | 0.5 | 0.5 | 0.5 |
| Crosslinking | 0.5 | 0.5 | 0.5 |
| Agent | | | |
| Crosslinking Auxiliary | 0.5 | 0.5 | 0.5 |
| Triazole | 1.0 | 1.0 | 1.0 |
| Metal Oxide A | 1.0 | 1.0 | |
| Metal Oxide B | | | |
| Metal Hydroxide A | | | |
| Power Generation Performance [%] | 15.37 | 13.25 | 13.11 |
| Appearance of Tab String | A | C | B |
| Transparency | C | A | A |

In the solar battery modules of Examples 1 to 8, the incident surface side encapsulants contained the EVA and the epoxy compound, and the back surface side encapsulants contained the EVA, and the metal oxide or the metal hydroxide. Therefore, the durability was excellent, and the appearance was also excellent. In addition, in the solar battery modules of Examples 5 and 6, the epoxy compound was further contained, and thus corrosion of the metal portion was limited, and the power generation efficiency was high.

In the solar battery module of Comparative Example 1, the incident surface side encapsulants contained the metal oxide and the epoxy compound, and thus the power generation efficiency deteriorated.

In the solar battery module of Comparative Example 2, the incident surface side encapsulants did not contain the epoxy compound, and thus corrosion of the tab string was confirmed.

In the solar battery module of Comparative Example 3, the back surface side encapsulants did not contain the metal oxide, and thus corrosion of the tab string was confirmed.

### Industrial Applicability

The encapsulants for a solar battery of the present invention limit corrosion of the metal portion due to the acetic acid, and are useful as encapsulants of a solar battery module having high power generation efficiency.

### Reference Signs List

- 10: SOLAR BATTERY MODULE
- 11: SOLAR BATTERY CELL
- 12: ENCAPSULANTS
- 13: TRANSPARENT PROTECTIVE MATERIAL
- 14: BACK SHEET
- 15: TAB STRING

## Claims

1. A pair of encapsulants for a solar battery for encapsulating a solar battery cell, comprising:
incident surface side encapsulants arranged on an incident surface side of solar light of the solar battery cell; and
back surface side encapsulants arranged on a back surface side of the solar battery cell,
wherein the incident surface side encapsulants contain an ethylene-vinyl acetate copolymer and an epoxy compound, and
the back surface side encapsulants contain an ethylene-vinyl acetate copolymer and an acid accepting agent formed of a metal compound.

2. A solar battery module,
wherein a solar battery cell is encapsulated by the encapsulants for a solar battery according to claim 1.

3. The encapsulants for a solar battery according to claim 1,
wherein an amount of a vinyl acetate unit in the ethylene-vinyl acetate copolymer is 10 mass% to 14 mass%.

4. The encapsulants for a solar battery according to claim 1,
wherein a mass average molecular weight of the ethylene-vinyl acetate copolymer is 10,000 to 300,000.

5. The encapsulants for a solar battery according to claim 1,
wherein the incident surface side encapsulants further contain a triazole compound.

6. The encapsulants for a solar battery according to claim 1,
wherein the incident surface side encapsulants further contain an ultraviolet absorbent.

7. The encapsulants for a solar battery according to claim 1,
wherein the incident surface side encapsulants further contain a silane coupling agent.

8. The encapsulants for a solar battery according to claim 1,
wherein the back surface side encapsulants further contain an epoxy compound.
